# EUROPÄISCHE PATENTSCHRIFT

(11) **EP 0 775 964 B1**
(45) Veröffentlichungstag und Bekanntmachung des Hinweises auf die Patenterteilung: **12.11.2003**
(21) Anmeldenummer: 96114512.5
(22) Anmeldetag: 11.09.1996
(51) Int. Cl.: G06K 7/06, G06K 19/077

(54) **Kontaktiereinheit für kartenförmige Trägerelemente elektronischer Baugruppen**
Contact unit for card-shaped carriers with electronic components
Unité de contact pour supports de composants électroniques en forme de carte

(30) Priorität: 25.11.1995 DE 29518707 U
(43) Veröffentlichungstag der Anmeldung: 28.05.1997
(73) Patentinhaber: STOCKO Contact GmbH & Co. KG, 42327 Wuppertal (DE)
(72) Erfinder: Klatt, Dieter, 42489 Wülfrath (DE); Bäcker, Arnd, 53940 Hellenthal (DE)
(74) Vertreter: Stenger, Watzke & Ring Patentanwälte

(56) Entgegenhaltungen:
- DE-U- 29 505 678
- US-A- 2 952 810
- US-A- 5 043 562
- US-A- 5 184 282

## Beschreibung

Die Erfindung betrifft eine Kontaktiereinheit für kartenförmige Trägerelemente elektronischer Baugruppen mit einem einen Einschubschlitz für das Trägerelement aufweisenden Gehäuse, in dem eine Leiterplatte angeordnet ist, die Kontaktelemente für die elektronischen Baugruppen aufweist und mit einem an einer Gehäusekante angeordneten Anschlußfeld, insbesondere nach der PCMCIA-Norm, verbunden ist, wobei das Gehäuse seitlich mit einer Ausnehmung für eine Einsteckchipkarte versehen ist. **Derartige Kontaktiereinheiten sind beispielsweise aus der DE 295 05 678 U oder der US-A-5 184 282 bekannt.**

Auch die US-A-5 043 562 zeigt eine kontaktiereinheit.

Im Bereich der Computertechnologie erwerben Multimedia-Anwendungen eine ständig wachsende Marktbedeutung. Folglich müssen übliche Personal-Computer für Anwendungen vorbereitet sein, die es dem Benutzer ermöglichen, Musik zu bearbeiten, Spielfilme zu betrachten oder Videobilder mit Bildbearbeitungsprogrammen zu individualisieren oder Spiele zu spielen. Ein an sich bekanntes Mittel, Personal-Computer für Multimedia-Anwendungen aufzurüsten, ist die Verwendung von kartenförmigen Trägerelementen von elektronischen Baugruppen, beispielsweise Multimedia-Cards (MMC), die einen Halbleiter-Chip, zum Beispiel 16, 64, 256 und > Mbit beinhalten. Solche kartenförmige Trägerelemente weisen stimseitige und/oder oberflächenseitige Kontaktbereiche auf und sind in Kontaktiereinheiten einschiebbar, wo sie elektrisch kontaktiert und in den Datenkreislauf des PC integriert werden. Die Kontaktfelder für die Kontaktierung eines Chips werden ebenfalls in insbesondere als Leseeinheiten ausgebildete Kontaktiereinheiten eingeschoben. Femer ist die Kombination derartiger Kartensysteme bekannt, wobei beispielsweise gleichzeitig eine PCMCIA- und eine Chip-Karte in eine entsprechende Kontaktiereinheit eingeschoben werden. Insbesondere sind bekannte kartenförmige Trägerelemente nach der PCMCIA-Norm ausgebildet und weisen dementsprechend ein normgemäßes matrixartiges Anschlußkontaktfeld und unterschiedlichste IC-Schaltkreise auf. Derartige Karten können Speichererweiterungskarten, Laufwerkskarten, Modemkarten und dgl. sein. Sie lassen sich in Kontaktiereinheiten mit einer entsprechenden Stiftmatrix kontaktieren, wozu sie in den Einschubschlitz beispielsweise eines Personal-Computers eingeschoben werden.

In der besonderen Anwendung für den Multimedia-Bereich werden die Chips der Multimedia-Cards werkseitig mit einem Programm versehen und ggf. mit einmalbeschreibbaren Speichern oder wiederbeschreibbaren Speichern ausgestattet. Die Multimedia-Card ist ein Seriellsystem und somit (wie CD-Wechsler) stapelbar für Blockspeichersysteme. Auf Multimedia-Cards werden zum Beispiel verpackte digitale Daten abgelegt und über ein Kontaktsystem mit metallischer Oberfläche ohne bewegliche Teile abgespielt. Die MMC dient als Speichermedium für Software, Nachschlagewerke, Straßenkarten, Reiseführer, Spiele, Musik usw. und findet Verwendung im PC, Handy, Organizer, Autoradio, Notebook usw., die hierzu mit einem Lesegerät ausgestattet sind. Die Verbindung zum Lesegerät wird mit der eingangs beschriebenen Kontaktiereinheit hergestellt.

Die bisher bekannten Kontaktiereinheiten können den anwendungstechnischen Anforderungen nicht mehr genügen. Nachteiligerweise ist allenfalls vorgesehen, eine PCMCIA-Karte in dem vom Anschlußfeld wegweisenden Bereich mit einer Ausnehmung für eine Chipkarte zu versehen, womit keine nennenswerte Variabilität erreicht wird (EP 0 552 078 A1). Gemäß **der** DE 295 05 678 **U** ist deshalb bei der dort vorbeschriebenen Kontaktiereinheit vorgesehen, noch einen zweiten zusätzlichen Einschubbereich in Form eines seitlichen Schlitzes für eine sogenannte Plug-in-Karte vorzusehen, so daß in der dortigen Kontaktiereinheit in Form einer PCMCIA-Karte gleichzeitig zwei Chip-Karten zusätzlich in das Lesegerät des Computers eingeführt werden können. Nachteiligerweise kann aber auch diese Ausführungsform einer Kontaktiereinheit nur begrenzte Anwendungsbereiche erschließen.

Der Erfindung liegt die **Aufgabe** zugrunde, eine gattungsgemäße Kontaktiereinheit dadurch zu verbessem, daß umfassende Anwendungen kartenförmiger Trägerelemente elektronischer Baugruppen miteinander kombinierbar sind, wobei insbesondere funktionale Verknüpfungen angestrebt werden, die Sicherungszwecken dienen oder Zugriffe eröffnen bzw. verschließen, um mißbräuchliche Anwendungen zu vermeiden. Dabei soll mit geringem wirtschaftlichen und apperativen Aufwand der Aufbau variabler Massenspeicherstrukturen ermöglicht werden.

Die Aufgabe ist an einer Kontaktiereinheit der eingangs genannten Art erfindungsgemäß dadurch gelöst, daß das Gehäuse zur Aufnahme und Kontaktierung einer Vielzahl, mindestens aber zwei, kartenförmiger Trägerelemente ausgebildet ist, **wobei die kartenförmigen Trägerelemente in wahlweiser Anordnungskombination** hintereinander, nebeneinander, versetzt zueinander, übereinander und/oder einander überlappend in einer oder mehreren Ebenen **durch den Einschubschlitz in dem Gehäuse anordbar** sind. Hierdurch wird es ermöglicht, in sehr einfacher Weise auf kleinstem Raum ein Massenspeichermedium aufzubauen, wie es beispielsweise in der Multimedia-Anwendung benötigt wird.

Die kartenförmigen Trägerelemente elektronischer Baugruppen sind in an sich bekannter Weise als ISO 7816 Chipkarten, vorzugsweise < als ISO 7816 Chipkarten, ausgebildet und weisen stimseitige Oberflächenkontaktfelder auf, die über mit der Leiterplatte verbundene Kontaktierelemente elektrisch mit dem Anschlußfeld, insbesondere der PCMCIA-Buchse verbunden sind. Dabei können die Kontaktfelder zweckmäßigerweise zur Bildung von Blockspeichern übereinander durchgängig kontaktiert sein, so daß die Anschlußverbindung zur Leiterplatte auch bei der Kombination von beispielsweise acht kartenförmigen Trägerelementen nur an zwei Kontaktstellen erfolgt.

Üblicherweise sind die Aufnahmen für kartenförmige Trägerelemente in der Kontaktiereinheit schlitzartig ausgebildet. In zweckmäßiger Ausgestaltung der Erfindung wird vorgeschlagen, den an die Abmessungen einer ISO 7816 Chipkarte angepaßten Schlitz mit einer in der Ansicht rechteckförmigen oben aufgesetzten rechteckförmigen Erweiterung zu versehen, so daß die Aufnahme verschieden kombinierter kartenförmiger Trägerelemente ermöglicht ist. Insbesondere ist dabei die Kombination einer ISO 7816 Chipkarte mit einer oder mehreren Multimedia-Cards in der Anordnung hintereinander, nebeneinander, versetzt zueinander, übereinander und/oder einander überlappend in einer oder zwei Ebenen möglich. An der Oberseite oder Unterseite der Kontaktiereinheit sind in der bevorzugten Ausführungsform dagegen Schrägschlitze nach SIMM-Technik als Aufnahmen vorgesehen, die eine große Packungsdichte für die kartenförmigen Trägerelemente bereitstellen. Dabei werden vorteilhafterweise die Schräg-Aufnahmen durch eine aufsteckbare oder aufschiebbare Abdeckung gegen Federwirkung in die Gehäuseebene eingeschwenkt und auf diese Weise unter Gewährleistung der kleinen Bauabmessungen der Kontaktiereinheit integriert und geschützt. Ferner sind auf den gegenüberliegenden Schmalseiten der Kontaktiereinheit mindestens je eine, vorzugsweise je zwei Schlitz-Aufnahmen für Multimedia-Halfcards mit entsprechenden inneren Kontaktierfeldern vorgesehen.

Die erfindungsgemäße Kontaktiereinheit ermöglicht vorteilhafterweise auch die Verwendung von mehreren Wechselmedien dann, wenn die Kontaktiereinheit beispielsweise in einem Notebook Verwendung findet und der bereitgestellte Netzanschluß nicht unterbrochen werden kann. In den stirnseitigen Einschubschlitz kann zum Beispiel eine ISO 7816 Chipkarte oder eine ähnliche Karte zur Autorisierung des Benutzers eingeschoben und kontaktiert werden, wobei eine Multimedia-Card oder zwei kleinere Multimedia-Cards in Halfcard-Ausgestaltung als wechselbare Datenträger Verwendung finden können. Bei der Anordnung mehrerer Multimedia-Cards koaxial hintereinander in der gleichen Ebene ist gemäß einer zweckmäßigen Ausgestaltung der Erfindung vorgesehen, im Gehäuse der Kontaktiereinheit ein Auswurffenster auszubilden, über welches der Benutzer die eingeführten kartenförmigen Trägerelemente wieder entnehmen kann. Alternativ zum Auswurffenster kann auch eine Auswurfmechanik vorgesehen sein.

Um die in das Gehäuse der Kontaktiereinheit eingesetzten kartenförmigen Trägerelemente elektronischer Baugruppen zu fixieren, wird gemäß einer zweckmäßigen Ausgestaltung der Erfindung vorgeschlagen, im Gehäuse für jede Aufnahme eine Rasteinrichtung anzuordnen, die mit einer entsprechenden korrespondierenden Ausbildung des kartenförmigen Trägerelementes nach dem Prinzip Vorsprung/Ausnehmung zusammenwirkt und zweckmäßigerweise zur Lösbarkeit der Verrastung federnd ausgebildet ist. Vorzugsweise ist das kartenförmige Trägerelement an gegenüberliegenden Seiten mit Ausnehmungen versehen, in die am Gehäuse befestigte Haltefedern zur Verrastung lösbar eingreifen.

Durch die erfindungsgemäße Kontaktiereinheit wird die Grundidee eines multifunktionalen Chipkartenlesers verwirklicht, in welchem mehrere Chipkarten in unterschiedlichen Positionen so angeordnet werden können, daß die zukünftigen Applikationen bezüglich Autorisierung, Massenspeicher im Bereich der Halbleitertechnik, Prozessorkarten und dgl. variabel seitens des Benutzers anwendbar sind. Durch die Kombination der unterschiedlichen kartenförmigen Trägerelemente in verschiedenen Formen und geometrischen Ausgestaltungen ist ein anwendungsabhängiger Einsatz ermöglicht, dem die erfindungsgemäße Kontaktiereinheit dadurch Rechnung trägt, daß eine Vielzahl von Multimedia-Karten integrierbar und lesbar sind.

Weitere Einzelheiten, Merkmale und Vorteile des Gegenstandes der Erfindung ergeben sich aus der nachfolgenden Beschreibung der zugehörigen Zeichnung, in der Kontaktiereinheiten oder deren Teile schematisch dargestellt sind. In der Zeichnung zeigt:
- Fig. 1: eine Kontaktiereinheit in ihrer Ausgestaltung als Multimedia-Card-Reader, perspektivisch in zwei Betriebszuständen,
- Fig. 2: eine Draufsicht des Multimedia-Card-Readers der Fig. 1 ohne Abdeckung ins Innere des Gehäuses hinein in Verbindung mit einer entsprechenden Seitenansicht,
- Fig. 3: den Multimedia-Card-Reader der Fig. 1 mit schematischer Verdeutlichung verschiedener Aufnahmen für kartenförmige Trägerelemente,
- Fig. 4: eine schematische Übersicht über die Gestaltung von Schlitzaufnahmen für verschiedene Multimedia-Cards und
- Fig. 5: die Kontaktiereinheit mit einer lösbaren Haube, perspektivisch in zwei Betriebszuständen.

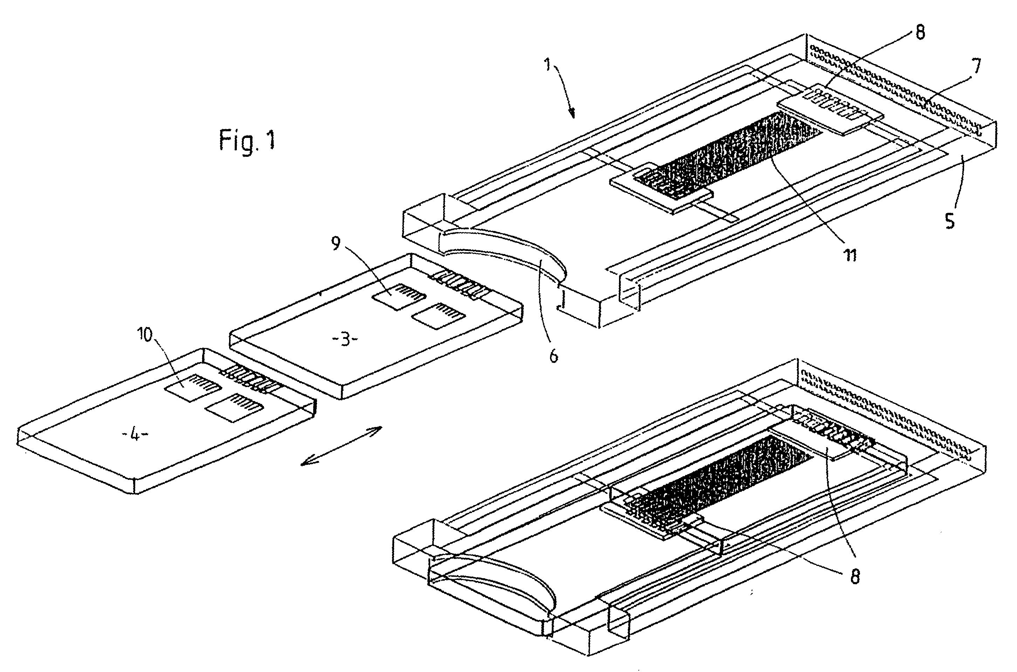

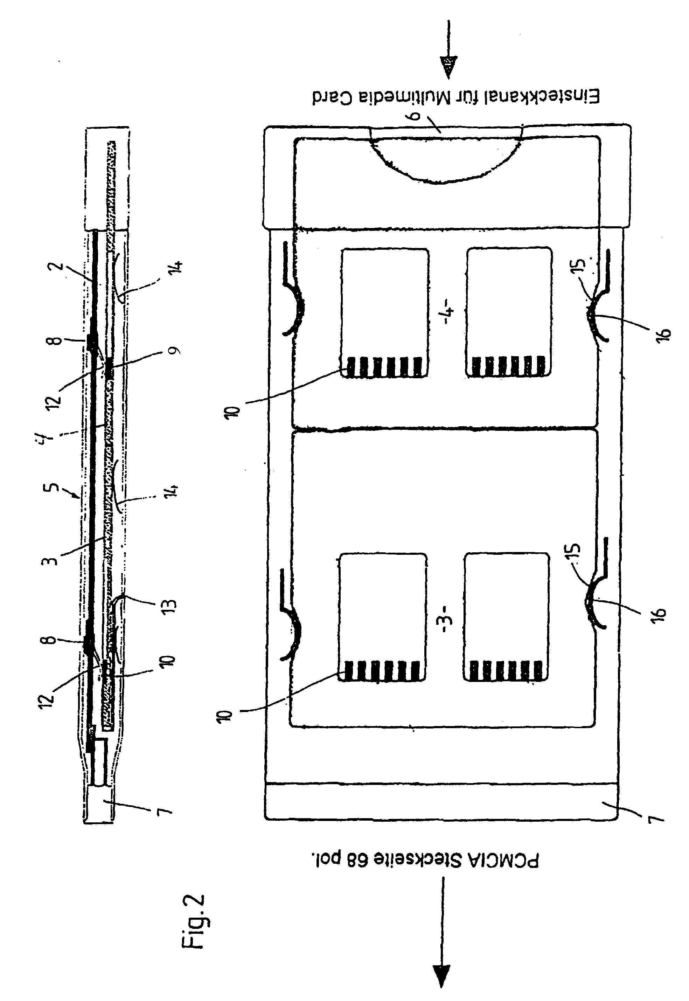

Die Kontaktiereinheit 1 des in Fig. 1 der Zeichnung dargestellten Ausführungsbeispiels weist eine aus Fig. 2 der Zeichnung erkennbare Leiterplatte 2 auf, die der Kontaktierung von zwei Multimedia-Karten 3, 4 als kartenförmige Trägerelemente elektronischer Baugruppen dient. Die Leiterplatte 2 ist in einem Gehäuse 5 angeordnet, welches auf der einen Seite eine schlitzförmige Aufnahme 6 für die kartenförmigen Trägerelemente 3 und 4 und auf der gegenüberliegenden Seite eine PCMCIA-Buchse 7 zur Verbindung beispielsweise mit einem Notebook aufweist. Die Multimedia-Cards 3 und 4 lassen sich in Richtung des gezeigten Doppelpfeils gemäß Fig. 1 der Zeichnung in die Kontaktiereinheit 1 mit PCMCIA-Karte einführen und aus dieser herausziehen. Im eingeführten Zustand, der im unteren Bild der Fig. 1 gezeichnet ist, erfaßt je eine sechspolige Kontaktbank, die von der Bauteilseite durch die Leiterplatte 2 verläuft, als Kontaktierelement 8 die jeweilige Multimedia-Card 3 bzw. 4, so daß über die entsprechenden sechspoligen Kontaktfelder 9 bzw. 10 die elektrische Kontaktierung der elektronischen Bauelemente der Multimedia-Cards mit der Kontaktiereinheit vorgenommen ist. Somit können die beiden Chipkarten über die PCMCIA-Karte verarbeitet werden, wenn die letztgenannte in den Einschubschlitz eines elektronischen Verarbeitungsgerätes und über die PCMCIA-Buchse 7 dort mit einem entsprechenden Kontaktfeld verbunden ist. Anwendungsbeispiele ergeben sich insbesondere aus dem Bereich der Multimedia-Verarbeitung, aber auch der Kommunikation, der Banken und dergleichen.

Das Gehäuse 5 der Kontaktiereinheit 1 weist zur Erleichterung der Bedienung an der schlitzförmigen Aufnahme 6 eine teilkreisförmige Ausnehmung auf, die es dem Benutzer ermöglicht, die zweite eingesteckte Multimedia-Card 4 wieder aus der Kontaktiereinheit 1 herauszuziehen. Um gleiches mit der zunächst eingeschobenen Multimedia-Card 3 durchführen zu können, ist auf der Oberseite des Gehäuses 5 ein Auswurffenster 11 ausgespart, durch welches der Benutzer mit seinem Daumen die darunter angeordnete Multimedia-Card 3 erfassen kann und durch die schlitzförmige Aufnahme 6 aus dem Gehäuse 5 ausschieben kann.

Fig. 2 der Zeichnung zeigt in beiden Bildern einen Einblick in das Innere der Kontaktiereinheit 1, woraus erkennbar wird, daß die Leiterplatte 2 mit ihren **Kontaktierelementen** 8 über nach unten greifende Kontaktfedem 12 mit den Kontaktfeldern 9, 10 der Multimedia-Cards 3 und 4 in Verbindung stehen, die aufgrund ihrer Federwirkung einen sicheren Andruck und eine sichere Kontaktierung gewährleisten. Unter den Multimedia-Cards 3 und 4 im Gehäuse 5 vorgesehene Andruckfedern 14 erhöhen die sichere Fixierung und Kontaktierung der Karten **3 und 4**. Darüber hinaus ist erkennbar, daß bei der Ausführungsform der Fig. 2 alternativ zum Auswurffenster 11 gemäß der Ausführungsform der Fig. 1 ein Auswerferhebel 13 im Gehäuse **5** vorgesehen ist, mit dem die innere Multimedia-Card 3 ebenfalls ausgeschoben werden kann.

Um die in das Gehäuse 5 der Kontaktiereinheit 1 eingesetzten kartenförmigen Trägerelemente **3 und 4** zu fixieren, ist eine Rasteinrichtung für jede Karte vorgesehen. Im unteren Bild der Fig. 2 ist als Rasteinrichtung gezeigt, daß jede Multimedia-Card 3 bzw. 4 auf gegenüberliegenden Seiten mit Ausnehmungen 15 versehen ist, in welche im eingesetzten Zustand am Gehäuse 5 seitlich befestigte **Rast**fedem 16 eingreifen, um insgesamt eine Rasteinrichtung zu bilden. Die Verrastung ist durch federndes nach außen Biegen der Rastfedern 16 zur Entnahme der Karten 3 und 4 lösbar.

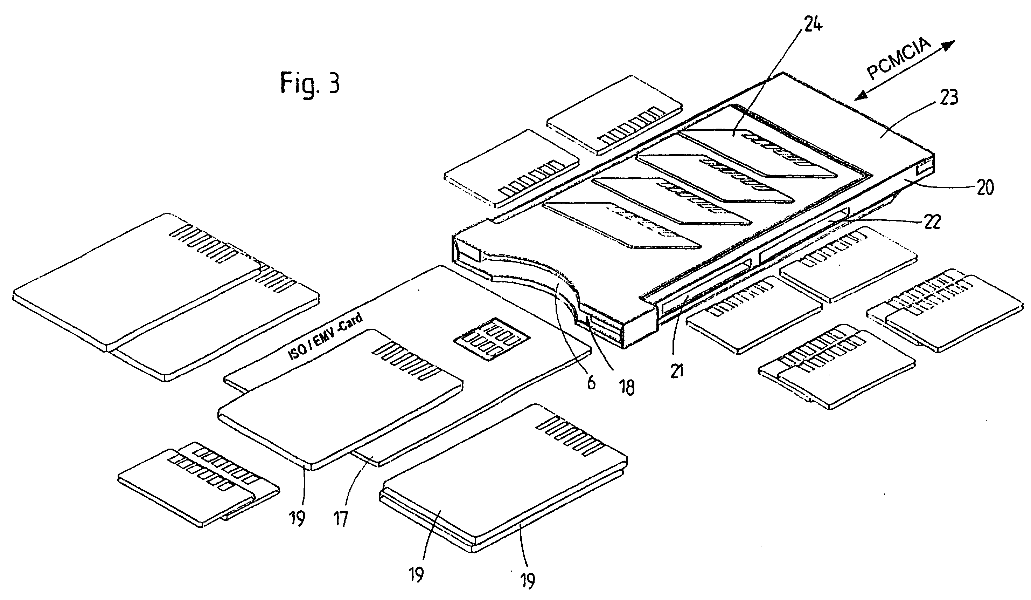

Fig. 3 der Zeichnung zeigt verschiedene Steckvarianten von kartenförmigen Trägerelementen in dafür vorgesehene Gehäuseaufnahmen, wobei in nicht dargestellter Weise innenliegende Kontaktierungen über Kontaktierelemente oder - felder mit der Leiterplatte 2, ggf. auch der Leiterplatten untereinander zur Blockbildung, vorgesehen sind.

Für den frontseitigen Einschub **ist** die schlitzförmige Aufnahme 6 mit einem breiten Basisschlitz für eine ISO 7816 Chipkarte 17 ausgebildet, wobei darüber eine rechteckförmige Erweiterung entsprechend dem Multimedia-Card-Format für eine Multimedia-Card 19 vorgesehen ist. Ein Einschub der beiden übereinander angeordneten Karten 17 und 19 in die Kontaktiereinheit 1 ist damit ermöglicht. Alternativ können auch zwei Multimedia-Cards in einer Anordnung übereinander oder versetzt zueinander, wie dies rechts und links in der Zeichnung verdeutlicht ist, eingesetzt werden. Weitere alternative Kombinationen sind zeichnerisch dargestellt, so daß an dieser Stelle ohne weitere Beschreibung hierauf verwiesen werden kann.

Das Gehäuse 5 der Kontaktiereinheit ist ferner an den beiden gegenüberliegenden Schmal-Längsseiten 20 mit schlitzförmigen Aufnahmen 21, 22 für Multimedia-Cards im Halbkartenformat versehen, wobei selbstverständlich wiederum innenliegende Kontaktiereinrichtungen vorhanden sind. Alternative Ausführungsformen sind ebenfalls zeichnerisch dargestellt.

Ferner sind auf der Oberseite 23 des Gehäuses vier Kartenaufnahmen 24 in Reihe hintereinander angeordnet, die eine schräggestellte Einführung der Multimedia-Cards entsprechend der an sich bekannten SIMM-Technik ermöglichen.

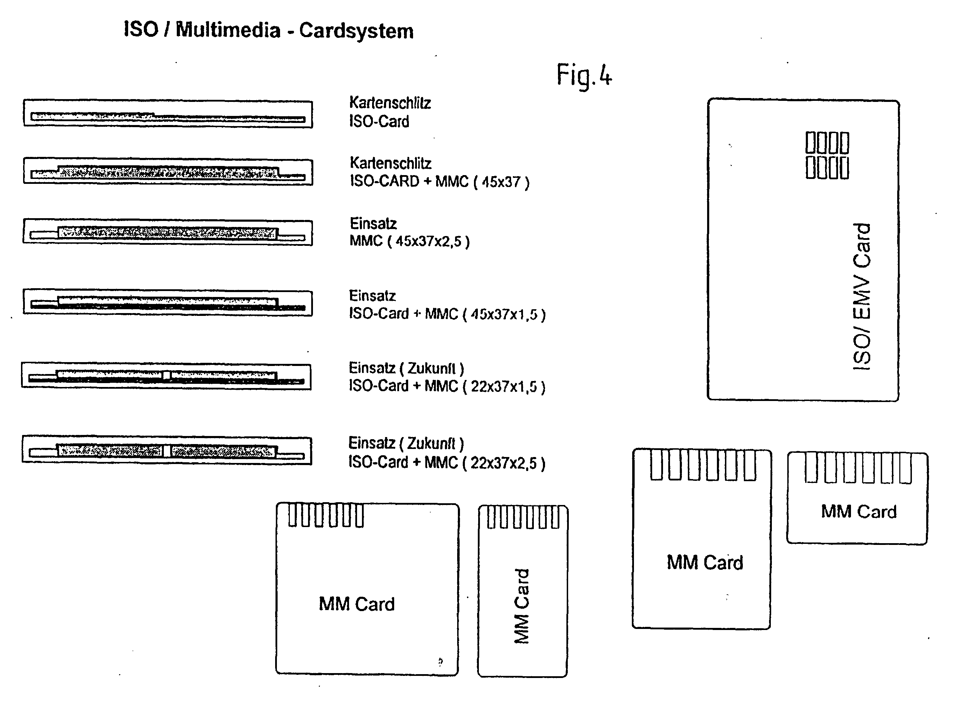

Bei sämtlichen Kartenaufnahmen wird mit Gehäuseschlitzen gearbeitet, die den Abmessungen der vorgesehenen Karten angepaßt sind. Fig. 4 der Zeichnung zeigt verschiedene Möglichkeiten der Ausbildung der Einschubschlitze der Kartenaufnahmen für die jeweils vorgesehenen Karten und Abmessungen sowie verschiedene Formate von Multimedia-Cards, die in der erfindungsgemäßen Kontaktiereinheit Verwendung finden können.

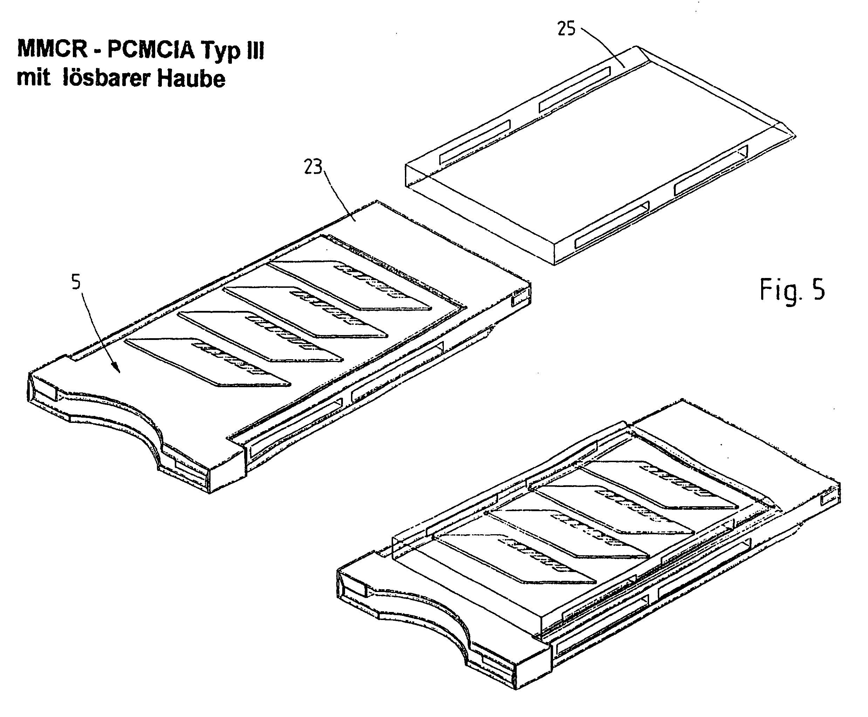

Bei dem in Fig. 5 der Zeichnung dargestellten Ausführungsbeispiel ist zusätzlich auf der Oberseite 23 des Gehäuses 5 eine aufschiebbare Abdeckung 25 vorgesehen, die in ihrer einfachsten Ausführungsform nur dazu dient, die Schrägaufnahmen 24 in die Ebene der Oberseite 23 gegen Federwirkung einzuklappen, um einen Schutz für die Multimedia-Cards bereitzustellen. Dies ist in dem unteren Bild der Fig. 5 im Benutzungszustand verdeutlicht. Es ist ferner angedeutet, daß auch die Abdeckung 25 ggf. ausgenutzt werden kann, Kartenaufnahmen mit entsprechenden Kontaktierungen zur Erweiterung der Anwendbarkeit der Kontaktiereinheit aufzunehmen.

### Bezugszeichenliste

- 1: Kontaktiereinheit
- 2: Leiterplatte
- 3: kartenförmiges Trägerelement elektronischer Baugruppen
- 4: kartenförmiges Trägerelement (Multimedia-Card)
- 5: Gehäuse
- 6: Einschubschlitz
- 7: PCMCIA-Buchse
- 8: Kontaktierelemente
- 9: Kontaktfelder
- 10: Kontaktfelder
- 11: Auswurffenster
- 12: Kontaktfedern
- 13: Auswerferhebel
- 14: Andruckfedern
- 15: Rastausnehmung
- 16: Rastfeder
- 17: ISO Chipkarte
- 18: Erweiterung
- 19: Multimedia-Card
- 20: Schmal-Längsseite
- 21: Kartenaufnahme
- 22: Kartenaufnahme
- 23: Oberseite
- 24: Kartenschrägaufnahme
- 25: Abdeckung

## Patentansprüche

1. Kontaktiereinheit (1) für kartenförmige Trägerelemente (3, 4) elektronischer Baugruppen mit einem einen Einschubschlitz (6) für das Trägerelement (3, 4) aufweisenden Gehäuse (5), in dem eine Leiterplatte (2) angeordnet ist, die Kontaktierelemente (8, 12) für die elektronischen Baugruppen aufweist und mit einem an einer Gehäusekante angeordneten Anschlußfeld, insbesondere nach der PCMCIA-Norm (7) verbunden ist, wobei das Gehäuse (5) seitlich mit einer Ausnehmung (21) für eine Einsteckchipkarte versehen ist,
**dadurch gekennzeichnet,**
**daß** das Gehäuse (5) zur Aufnahme und Kontaktierung einer Vielzahl, mindestens aber zwei, kartenförmiger Trägerelemente (3, 4, 17, 19) ausgebildet ist, wobei die kartenförmigen Trägerelemente (3, 4, 17, 19) in wahlweiser Anordnungskombination hintereinander und/oder nebeneinander und/oder versetzt zueinander und/oder übereinander und/oder einander überlappend in einer oder mehreren Ebenen durch den Einschubschlitz (6) in dem Gehäuse (5) anordbar sind.

2. Kontaktiereinheit nach Anspruch 1, **dadurch gekennzeichnet, daß** die kartenförmigen Trägerelemente (3, 4, 19) Oberflächenkontaktfelder und/oder stimseitige Oberflächenkontaktfelder aufweisen, die über mit der Leiterplatte (2) verbundene Kontaktierelemente (8) elektrisch mit dem Anschlußfeld, insbesondere der PCMCIA-Buchse (7), verbindbar sind.

3. Kontaktiereinheit nach Anspruch 1 oder Anspruch 2, **dadurch gekennzeichnet, daß** der **in der Ansicht im wesentlichen rechteckförmige** Einschubschlitz (6) mit **einer in der Ansicht oben aufgesetzten rechteckförmigen** Erweiterung (18) **versehen ist, so daß die** Aufnahme verschiedener miteinander kombinierter kartenförmiger Trägerelemente **ermöglicht** ist.

4. Kontaktiereinheit nach einem der Ansprüche 1 bis 3, **gekennzeichnet durch** die Kombination einer ISO 7816 Chipkarte mit einer oder mehreren Multimedia-Cards in der Anordnung hintereinander und/oder nebeneinander und/oder versetzt zueinander und/oder übereinander und/oder einander überlappend in einer oder zwei Ebenen.

5. Kontaktiereinheit nach einem der Ansprüche 1 bis 4, **gekennzeichnet durch** an der Oberseite und/oder Unterseite des Gehäuses (5) vorgesehene Schrägschlitze nach SIMM-Technik als Aufnahmen (24) für die kartenförmigen Trägerelemente.

6. Kontaktiereinheit nach Anspruch 5, **gekennzeichnet durch** eine aufsteckbare oder aufschiebbare Abdeckung (25).

7. Kontaktiereinheit nach einem der Ansprüche 1 bis 6, **gekennzeichnet durch** je zwei Schlitz-Aufnahmen (21, 22) auf den gegenüberliegenden Schmal-Längsseiten (20) für Multimedia-Halfcards.

8. Kontaktiereinheit nach einem der Ansprüche 1 bis 7, **dadurch gekennzeichnet, daß** im Gehäuse (5) ein Auswurffenster (11) oder eine Auswurfmechanik (13) vorgesehen ist.

9. Kontaktiereinheit nach einem der Ansprüche 1 bis 8, **dadurch gekennzeichnet, daß** die eingesetzten kartenförmigen Trägerelemente elektronischer Baugruppen durch eine Rasteinrichtung (15, 16) lösbar fixiert sind.

## Claims

1. Contact unit (1) for card-shaped carriers (3,4) with electronic components with a housing (5) with insertion slot (6) for the carrier (3,4), in which housing a circuit board (2) is disposed that has contact elements (8,12) for the electronic components and is linked to a connecting field at the edge of the housing, in particular in accordance with the PCMCIA Standard (7), where the housing (5) is provided with a recess (21) on its side for a push-in chipcard,
**characterised in that** the housing (5) is designed for the accommodation and connection of a plurality, but at least two, card shaped carriers (3, 4, 17,19), where the card-shaped carriers (3, 4, 17, 19) can be arranged in the housing (5) in an optional array one behind another and/or adjacent to one another and/or offset relative to one another and/or one on top of another and/or overlapping one another on one or several levels, through the insertion slot (6).

2. Contact unit in accordance with Claim 1, **characterised in that** the card-shaped carriers (3, 4, 19) have surface contact fields and/or end face surface contact fields which can be electrically connected through contacts (8) connected to the circuit board (2) with the connecting field, especially the PCMCIA socket (7).

3. Contact unit in accordance with claim 1 or claim 2, **characterised in that** the substantially rectangular insertion slot (6) in the view is provided with a rectangular extension (18) placed on top in the view so that it becomes possible to accommodate several card-shaped carriers in combination with one another.

4. Contact unit in accordance with one of claims 1 to 3, **characterised by** the combination of an ISO 7816 chipcard with one or several multimedia cards arranged one behind another and/or adjacent to one another and/or offset relative to one another and/or one on top of another and/or overlapping each other on one or two levels.

5. Contact unit in accordance with one of claims 1 to 4, **characterised by** diagonal slots of SIMM construction provided on the top and/or the bottom of the housing (5) as holders (24) for the card-shaped carriers.

6. Contact unit in accordance with claim 5, **characterised by** a cover (25) which can be pushed or slid into position.

7. Contact unit in accordance with one of claims 1 to 6, **characterised by** two holding slots (21, 22) for multimedia halfcards on the narrow longitudinal opposing sides (20).

8. Contact unit in accordance with one of claims 1 to 7, **characterised in that** the housing (5) is provided with an ejection window (11) or an ejection mechanism (13).

9. Contact unit in accordance with one of claims 1 to 8, **characterised in that** the inserted card-shaped carriers with electronic components are detachably retained in their position by a latching device (15, 16).

## Revendications

1. Unité de contact (1) destinée à des éléments de support en forme de carte (3, 4) de composants électroniques, comportant un boîtier (5) muni d'une fente d'insertion (6) pour l'élément de support (3, 4), dans lequel est disposée une carte à circuits imprimés (2) munie d'éléments de contact (8, 12) pour les composants électroniques, et un champ de raccordement, notamment d'après la norme PCMCIA (7) agencé sur un bord du boîtier, le boîtier (5) étant muni latéralement d'un évidement (21) destiné à une carte à puce d'insertion,
**caractérisée en ce que**
le boîtier (5) est agencé pour la réception et l'établissement de contact d'une pluralité d'éléments de support en forme de carte (3, 4, 17, 19), cependant au moins deux, les éléments de support en forme de carte (3, 4, 17, 19) pouvant être disposés dans le boîtier (5) à travers la fente d'insertion (6) selon une combinaison de disposition, au choix, les uns derrière les autres et/ou côte à côte et/ou en étant décalés les uns par rapport aux autres et/ou superposés et/ou en se chevauchant dans un ou plusieurs plans.

2. Unité de contact selon la revendication 1, **caractérisée en ce que** les éléments de support en forme de carte (3, 4, 19) comportent des champs de contact de surface et/ou des champs de contact de surface en face frontale, qui peuvent être reliés électriquement au champ de raccordement, notamment à la douille PCMCIA (7), par l'intermédiaire d'éléments de contact (8) reliés à la carte à circuits imprimés (2).

3. Unité de contact selon la revendication 1 ou la revendication 2, **caractérisée en ce que** la fente d'insertion (6), qui est sensiblement rectangulaire en projection, est munie d'un élargissement rectangulaire (18) rapporté en projection en partie supérieure, de sorte que la réception permette l'insertion d'éléments de support en forme de carte de différentes combinaisons.

4. Unité de contact selon l'une quelconque des revendications 1 à 3, **caractérisée par** la combinaison d'une carte à puce ISO 7816 avec une ou plusieurs cartes multimédias disposées les unes derrière les autres et/ou côte à côte et/ou en étant décalées les unes par rapport aux autres et/ou superposées et/ou en se chevauchant dans un ou deux plans.

5. Unité de contact selon l'une quelconque des revendications 1 à 4, **caractérisée par** des fentes obliques selon la technique SIMM prévues sur la face supérieure et/ou la face inférieure du boîtier (5) en tant que réceptions (24) pour les éléments de support en forme de carte.

6. Unité de contact selon la revendication 5, **caractérisée par** un couvercle emboîtable ou coulissant (25).

7. Unité de contact selon l'une quelconque des revendications 1 à 6, **caractérisée par** des réceptions (21, 22) en forme de fente pour des demi-cartes multimédias prévues sur les côtés longs étroits (20) opposés.

8. Unité de contact selon l'une quelconque des revendications 1 à 7, **caractérisée en ce qu'**une fenêtre d'éjection (11) ou un mécanisme d'éjection (13) est prévue dans le boîtier (5).

9. Unité de contact selon l'une quelconque des revendications 1 à 8, **caractérisée en ce que** les éléments de support en forme de carte de composants électroniques insérés sont fixés de façon amovible par un dispositif d'encliquetage (15, 16).
